# EUROPÄISCHE PATENTSCHRIFT

(11) **EP 3 533 239 B1**
(45) Veröffentlichungstag und Bekanntmachung des Hinweises auf die Patenterteilung: **27.01.2021**
(21) Anmeldenummer: 17794701.7
(22) Anmeldetag: 25.10.2017
(51) Int. Cl.: H04R 3/00, H03G 3/30

(54) **VERSTÄRKEREINHEIT ZUM BETREIBEN EINES PIEZOELEKTRISCHEN SCHALLWANDLERS UND/ODER EINES DYNAMISCHEN SCHALLWANDLERS SOWIE EINE SCHALLERZEUGUNGSEINHEIT**
AMPLIFIER FOR DRIVING A PIEZO-TRANSDCUER AND/OR A DYNAMIC TRANSDUDER AND SOUND GENERATING UNIT
AMPLIFICATEUR À ALIMENTER UN HAUT-PARLEUT PIEZO ET/OU UN HAUT-PARLEUR DYNAMIQUE ET UNITÉ DE GÉNÉRATION DE SON

(30) Priorität: 27.10.2016 DE 102016120545
(43) Veröffentlichungstag der Anmeldung: 04.09.2019
(73) Patentinhaber: Usound GmbH, 8020 Graz (AT)
(72) Erfinder: RUSCONI CLERICI BELTRAMI, Andrea, 1130 Wien (AT); BOTTONI, Ferruccio, 8020 Graz (AT); HÄNSLER, Markus, 8081 Heiligenkreuz am Waasen (AT)
(74) Vertreter: Bergmeier, Ulrich
(86) Internationale Anmeldenummer: PCT/EP2017/077250
(87) Internationale Veröffentlichungsnummer: WO 2018/077922

(56) Entgegenhaltungen:
- US-A1- 2004 017 921
- US-A1- 2006 093 153
- Michael Ressing ET AL: "Analoger Leistungsverstärker mit Energierückgewinnung für piezoelektrische Aktoren", , 12. Juni 2007 (2007-06-12), Seiten 1-6, XP055439729, DOI: 10.1016/j.mechatronics.2008.06.009 Gefunden im Internet: URL:http://www.lpa.uni-saarland.de/pdf/200 7/022_Ressing.pdf [gefunden am 2018-01-10]

## Beschreibung

Die Erfindung betrifft eine Verstärkereinheit zum Betreiben eines piezoelektrischen Schallwandlers und/oder eines dynamischen Schallwandlers. Die Verstärkereinheit umfasst außerdem zumindest einen Audioverstärker. Ferner umfasst die Erfindung eine Schallerzeugungseinheit mit einer Verstärkereinheit, die ein Audiosignal verstärkt und einem Schallwandler zuführt.

Im allgemeinen Stand der Technik sind Verstärkereinheiten für Schallwandler bekannt. Diese können allerdings nur für einen piezoelektrischen Schallwandler oder einen dynamischen Schallwandler genutzt werden. Nachteilig dabei ist zum einen, dass für die beiden Schallwandler auch zwei dazugehörige Verstärkereinheiten vorhanden sein müssen. Zum anderen ist es problematisch die Schallwandlerart, d.h. piezoelektrisch oder elektrodynamisch, festzustellen, wenn darüber keine Information vorhanden ist. So kann es ferner zu Beschädigungen kommen, wenn ein piezoelektrischer Schallwandler mit einer Verstärkereinheit für einen dynamischen Schallwandler betrieben wird, oder umgekehrt.

US2006/0093153 zeigt eine Verstärkerschaltung, die sowohl einen dynamischen wie einen piezoelektrischen Schallwandler ansteuern kann. Anhand einer Versorgungsspannung wird der Typ des Wandlers erkannt und die Verstärkung der Verstärkerschaltung entsprechend eingestellt.

US2004/0017921 zeigt eine Verstärkerschaltung zum Betreiben eines dynamischen oder eines piezoelektrischen Schallwandlers. Über Impedanzmessungen der Impedanz eines angeschlossenen Wandlers kann festgestellt werden, ob sich die akustischen Bedingungen des Wandler verändert haben. Ein Filter kann dann diese Änderungen ausgleichen.

Aufgabe der vorliegenden Erfindung ist es somit, diese Nachteile zu beseitigen.

Die Aufgabe wird gelöst durch eine Verstärkereinheit und einer Schallerzeugungseinheit mit den Merkmalen der unabhängigen Patentansprüche.

Vorgeschlagen wird eine Verstärkereinheit zum Betreiben eines piezoelektrischen Schallwandlers und/oder eines dynamischen Schallwandlers. Die Verstärkereinheit umfasst dabei zumindest einen Audioverstärker. Ein Schallwandler kann dabei einen Lautsprecher, zum Erzeugen von Tönen, Musik und/oder Sprache, und/oder ein Mikrofon, zum Aufnehmen von Tönen, Musik und/oder Sprache, umfassen.

Erfindungsgemäß umfasst die Verstärkereinheit eine Erkennungseinheit, mittels der erkennbar ist, ob ein mit der Verstärkereinheit gekoppelter Schallwandler ein piezoelektrischer Schallwandler und/oder ein dynamischer Schallwandler ist. Die Erkennungseinheit kann den Schallwandler auch automatisiert erkennen. Ein Audiosignal für einen piezoelektrischen Schallwandler kann beispielsweise auf eine andere Weise verstärkt werden als ein Audiosignal für einen dynamischen Schallwandler. Wenn nun zuerst erkannt wird welche Art Schallwandler vorliegt, kann das Audiosignal dementsprechend verstärkt werden, so dass mit einer Verstärkereinheit ein piezoelektrischer und/oder ein dynamischer Schallwandler betrieben werden kann. Dadurch kann die Verstärkereinheit flexibel eingesetzt werden, da nur noch eine Verstärkereinheit für einen piezoelektrischen und/oder dynamischen Schallwandler verwendet wird.

Die Verstärkereinheit ist derart konfiguriert (d.h. derart programmiert), dass diese ein Testsignal an den zumindest einen verbundenen Schallwandler schickt. Das Testsignal kann vorzugsweise automatisiert nach dem Verbinden eines Schallwandlers von der Verstärkereinheit geschickt werden. Das Testsignal wird dabei an den Schallwandler geschickt um zu erkennen, ob ein piezoelektrischer und/oder ein dynamischer Schallwandler mit der Verstärkereinheit verbunden ist.

Der piezoelektrische Schallwandler kann dabei beispielsweise einen MEMS-Lautsprecher und/oder ein MEMS-Mikrofon umfassen. Der piezoelektrische Schallwandler basiert auf dem piezoelektrischen Effekt. Der piezoelektrische Schallwandler umfasst ein Piezo-Bauteil, das bei Anlegen einer Spannung aufgeladen wird, wobei es sich verformt. Durch die Verformungen und beispielsweise einer Membran kann ein Schall erzeugt werden. Das Piezo-Bauteil weist außerdem eine Kapazität, die aufgeladen wird.

Der dynamische Schallwandler kann dagegen beispielsweise darauf basieren, dass ein Magnet gegenüber einer Spule ausgelenkt wird. Als Beispiel wird in einem dynamischen Lautsprecher die Spule mit einer Spannung beaufschlagt, die einen elektrischen Strom in der Spule hervorruft. Der Strom in der Spule führt zu einem Magnetfeld, welches den Magneten anzieht oder abstößt, so dass der Magnet ausgelenkt wird. Der Magnet kann mit einer Membran verbunden sein, so dass diese bei der Auslenkung mit ausgelenkt wird. Durch die Auslenkung wird hier der Schall erzeugt. Der dynamische Schallwandler kann dabei eine Induktivität umfassen. Der dynamische Schallwandler kann auch ein elektrodynamischer Schallwandler sein.

In einer vorteilhaften Weiterbildung der Erfindung umfasst die Verstärkereinheit einen ersten Audioverstärker für den piezoelektrischen Schallwandler und einen zweiten Audioverstärker für den dynamischen Schallwandler. Dadurch kann der erste Audioverstärker für den Betrieb des piezoelektrischen Schallwandlers und der zweite Audioverstärker für den Betrieb des dynamischen Schallwandlers optimiert werden. Dadurch kann die Verstärkereinheit mit einem höheren Wirkungsgrad betrieben werden.

Ferner ist es von Vorteil, wenn die Verstärkereinheit zumindest eine Schnittstelle umfasst, über die zumindest ein Schallwandler mit der Verstärkereinheit und/oder der Erkennungseinheit verbunden ist. Zusätzlich oder alternativ kann der zumindest eine Schallwandler mit der Verstärkereinheit und/oder der Erkennungseinheit auch verbunden werden. Die Schnittstelle kann auch kabelgebunden sein. Beispielsweise kann die Schnittstelle eine Buchse für einen Stecker sein.

Ebenso ist es vorteilhaft, wenn die Schnittstelle zumindest eine Testleitung zum Verbinden der Erkennungseinheit mit dem zumindest einen Schallwandler umfasst. Dadurch kann die Erkennungseinheit separat mit dem Schallwandler verbunden werden.

Zusätzlich oder alternativ kann die Schnittstelle zumindest eine Audioleitung zum Verbinden eines Audioverstärkers mit dem zumindest einen Schallwandler umfassen. Über die Audioleitung kann das verstärkte Audiosignal zum Schallwandler geführt werden.

Vorteilhaft ist es auch, wenn die Schnittstelle bidirektional ausgebildet ist, so dass von der Verstärkereinheit Signale an den zumindest einen Schallwandler geschickt und von diesem empfangen werden können. Dabei können auch die Testleitung und/oder die Audioleitung bidirektional ausgebildet sein. Wenn beispielsweise der Schallwandler als Mikrofon ausgebildet ist, kann die Verstärkereinheit von dem Mikrofon Signale empfangen. Dadurch ist ein Betrieb der Verstärkereinheit für Lautsprecher und/oder Mikrofone gegeben.

Von Vorteil ist es ebenso, wenn die Verstärkereinheit eine Schalteinheit aufweist, mittels der zumindest einer der Audioverstärker auswählbar ist. Zusätzlich oder alternativ kann auch ein Audiosignal zu dem ausgewählten Audioverstärker geleitet werden. Wenn beispielsweise nur ein dynamischer Schallwandler an die Verstärkereinheit gekoppelt ist, kann nur der zweite Audioverstärker ausgewählt werden, um den dynamischen Schallwandler zu betreiben. In diesem Fall bleibt der erste Audioverstärker inaktiv, so dass Energie eingespart werden kann.

Des Weiteren ist es vorteilhaft, wenn die Verstärkereinheit eine Steuereinheit zum Steuern der Schalteinheit umfasst. Die Steuereinheit kann zwischen der Schalteinheit und der Erkennungseinheit angeordnet und/oder mit diesen elektrisch verbunden sein. Die Steuereinheit kann dadurch die Erkennungseinheit überwachen und wenn diese den Schallwandler erkennt, kann die Steuereinheit die Schalteinheit entsprechend steuern.

Außerdem ist es von Vorteil, wenn die Erkennungseinheit derart konfiguriert ist (d.h. derart programmiert ist), dass diese das Testsignal an den zumindest einen verbundenen Schallwandler schickt. Zusätzlich oder alternativ kann auch die Steuereinheit derart konfiguriert sein, dass diese das Testsignal an den zumindest einen verbundenen Schallwandler schickt. Das Testsignal kann außerdem automatisiert nach dem Verbinden eines Schallwandlers von der Erkennungseinheit und/oder Steuereinheit geschickt werden. Das Testsignal wird dabei an den Schallwandler geschickt um zu erkennen, ob ein piezoelektrischer und/oder ein dynamischer Schallwandler mit der Verstärkereinheit verbunden ist.

Die Erkennungseinheit ist derart konfiguriert, dass diese ein auf das Testsignal resultierendes Antwortsignal des Schallwandlers empfängt und analysiert. Dabei kann die Erkennungseinheit zwischen einem kapazitiven und einem induktiven Antwortsignal unterscheiden.

Der Schallwandler erhält somit das Testsignal und verändert es derart, dass er das Antwortsignal zurückschickt. Zusätzlich oder alternativ kann der Schallwandler das Testsignal auch nur verändern und die Erkennungseinheit erkennt das Antwortsignal.

Beispielsweise erkennt die Erkennungseinheit das kapazitive Antwortsignal. Anhand dieses kapazitiven Antwortsignals kann die Erkennungseinheit erkennen, dass ein piezoelektrischer Schallwandler an die Verstärkereinheit angeschlossen ist. Der piezoelektrische Schallwandler kann sich beispielsweise dadurch kennzeichnen, dass darin ein Piezo-Bauteil angeordnet ist. Das Piezo-Bauteil weist dabei eine Kapazität auf, die auf das Testsignal das kapazitive Antwortsignal zurückgibt. Das Piezo-Bauteil weist außerdem elektrische Eigenschaften auf, die im Wesentlichen dem eines Kondensators ähneln. Die Erkennungseinheit kann daher als Testsignal den Schallwandler beispielsweise mit einer konstanten Spannung beaufschlagen. Nach einer Aufladezeit des piezoelektrischen Schallwandlers ist dieser aufgeladen, so dass ein elektrischer Stromfluss zum piezoelektrischen Schallwandler zum Erliegen kommt. Das Antwortsignal ist somit hier das zum Erliegen kommen des elektrischen Stroms. Zusätzlich oder alternativ kann die Erkennungseinheit beispielsweise auch den frequenzabhängigen Widerstand des piezoelektrischen Schallwandlers messen, so dass das kapazitive Antwortsignal beispielsweise die Abhängigkeit des Widerstands des piezoelektrischen Schallwandlers von der Frequenz einer Spannung ist.

Ein induktives Antwortsignal liegt nun vor, wenn ein dynamischer Schallwandler an die Verstärkereinheit angeschlossen ist, wobei die Erkennungseinheit dieses Antwortsignal erkennen kann. Der dynamische Schallwandler kann beispielsweise eine Spule umfassen, die eine Induktivität aufweist. Die Erkennungseinheit kann beispielsweise als Testsignal den Schallwandler wieder mit einer konstanten Spannung beaufschlagen. Ist darin eine Spule angeordnet, wird sich nach einer gewissen Aufladezeit der Spule ein konstanter und von Null verschiedener elektrische Strom ausbilden. Der Schallwandler gibt somit als induktives Antwortsignal einen konstanten Strom zurück, was ein Hinweis auf den dynamischen Schallwandler ist. Die Erkennungseinheit kann aber auch hier den frequenzabhängigen Widerstand des Schallwandlers messen, um anhand dessen auf den dynamischen Schallwandler zu schließen.

Auch ist es von Vorteil, wenn die Erkennungseinheit derart konfiguriert ist, dass diese im Falle eines kapazitiven Antwortsignals einen piezoelektrischen Schallwandler und im Falle eines induktiven Antwortsignals einen dynamischen Schallwandler identifiziert und der Steuereinheit ein korrespondierendes Ergebnissignal übermittelt. Die Erkennung des Antwortsignals kann wie oben beschrieben durchgeführt werden. Nach dem Erkennen kann die Erkennungseinheit der Steuereinheit das Ergebnis in Form eines Ergebnissignals übermitteln.

Ferner ist es vorteilhaft, wenn die Steuereinheit derart konfiguriert ist, dass diese die Schalteinheit in Abhängigkeit des Ergebnissignals ansteuert, so dass das Audiosignal an den ersten und/oder an den zweiten Audioverstärker leitbar ist. Erhält die Steuereinheit beispielsweise ein Ergebnissignal von der Erkennungseinheit, dass auf einen angeschlossenen piezoelektrischen Schallwandler hinweist, steuert die Steuereinheit die Schalteinheit derart, dass das Audiosignal zum ersten Audioverstärker geleitet wird. Weist das Ergebnissignal zusätzlich oder alternativ auf einen dynamischen Schallwandler hin, wird das Audiosignal zum zweiten Audioverstärker geleitet.

Daneben ist es von Vorteil, wenn die Verstärkereinheit eine Versorgungseinheit umfasst, mittels der dem ersten Audioverstärker eine elektrische Spannung bereitgestellt werden kann. Für das Betreiben eines piezoelektrischen Schallwandlers können beispielsweise höhere Spannungen benötigt werden, als beispielsweise durch einen Akkumulator in einem Smartphone bereitgestellt werden kann. Dort werden üblicherweise Spannungen von 3-4 V durch den Akku geliefert. Ein in dem piezoelektrischen Schallwandler angeordnetes Piezo-Bauteil kann jedoch höhere Spannungen benötigen. Mittels der Versorgungseinheit kann die höhere Spannung bereitgestellt werden. Beispielsweise umfasst die Versorgungseinheit eine Ladungspumpe und/oder einen Aufwärtswandler zur Erzeugung der höheren Spannung.

Darüber hinaus ist es auch von Vorteil, wenn der erste Audioverstärker eine Energierückgewinnungseinheit umfasst, mittels der elektrische Energie vom piezoelektrischen Schallwandler zurückgewonnen wird. Wie bereits beschrieben ist, kann der piezoelektrische Schallwandler eine Kapazität aufweisen. Diese Kapazität wird beispielsweise beim Auslenken des Piezo-Bauteils aufgeladen. Bei einem Zurückkehren des Piezo-Bauteils in eine Ausgangslage wird die Kapazität wieder entladen, wodurch Energie von der Kapazität abgegeben wird. Diese Energie kann für ein weiteres Aufladen in der Energierückgewinnungseinheit zumindest zeitweise zwischengespeichert werden, so dass Energie eingespart wird.

Vorgeschlagen wird des Weiteren ein Verfahren zum Betreiben zumindest eines Schallwandlers bei dem mittels einer Verstärkereinheit ein Audiosignal für den zumindest einen Schallwandler verstärkt wird. Der Schallwandler kann beispielsweise ein piezoelektrischer und/oder ein dynamischer Schallwandler sein. Die Verstärkereinheit kann dabei nach einem oder mehreren Merkmalen der vorangegangenen und/oder nachfolgenden Beschreibung ausgebildet sein.

Erfindungsgemäß wird dabei mittels einer Erkennungseinheit erkannt, ob der zumindest eine Schallwandler ein piezoelektrischer Schallwandler oder ein dynamischer Schallwandler ist. Zusätzlich oder alternativ wird daraufhin die Verstärkereinheit das Audiosignal entsprechend verstärken. Zusätzlich oder alternativ kann auch die in der Beschreibung beschriebene Verstärkereinheit mit einem derartigen Verfahren betrieben werden.

Ferner wird eine Schallerzeugungseinheit mit zumindest einem Schallwandler und einer Verstärkereinheit vorgeschlagen. Der zumindest eine Schallwandler kann dabei ein piezoelektrischer und/oder ein dynamischer Schalwandler sein. Die Verstärkereinheit verstärkt außerdem ein Audiosignal und führt es dem Schallwandler zu.

Erfindungsgemäß ist die Verstärkereinheit nach zumindest einem Merkmal der vorangegangenen und/oder nachfolgenden Beschreibung ausgebildet.

In einer vorteilhaften Weiterbildung der Erfindung ist der Schallwandler fest oder lösbar mit der Verstärkereinheit verbunden.

Beispielsweise ist der Schallwandler in einem Smartphone, Tablet und/oder einem Laptop fest mit der Verstärkereinheit verbunden. Dort ist die Schallerzeugungseinheit in dem Smartphone und/oder Laptop mit integriert.

Zusätzlich oder alternativ kann der Schallwandler auch in einem Kopfhörer oder beispielsweise einer anderen Lautsprecheranordnung angeordnet sein. Beispielsweise kann der Kopfhörer lösbar an das Smartphone angeschlossen werden, um von dem Smartphone Musik abzuspielen. Die Verstärkereinheit erkennt dabei, ob ein piezoelektrischer und/oder ein dynamischer Lautsprecher in dem Kopfhörer angeordnet ist und verstärkt ein Audiosignal, das die Musik enthält, indem das Audiosignal einem Audioverstärker für den piezoelektrischen und/oder einem Audioverstärker für den dynamischen Lautsprecher zugeführt wird.

Vorgeschlagen wird ein Verfahren für eine Verstärkereinheit zum Betreiben eines piezoelektrischen Schallwandlers und/oder eines dynamischen Schallwandlers. Die Verstärkereinheit umfasst zumindest einen Audioverstärker. Des Weiteren ist die Verstärkereinheit gemäß der vorangegangenen Beschreibung ausgebildet, wobei die genannten Merkmale einzeln oder in beliebiger Kombination vorhanden sein können. Mittels einer Erkennungseinheit der Verstärkereinheit wird, insbesondere automatisiert, erkannt, ob ein mit der Verstärkereinheit gekoppelter Schallwandler ein piezoelektrischer oder ein dynamischer Schallwandler ist. Dadurch kann der Audioverstärker ein Audiosignal für den Schallwandler entsprechend der Art des Schallwandlers verstärken. Außerdem schickt die Verstärkereinheit, insbesondere automatisiert nach dem Verbinden eines Schallwandlers, ein Testsignal an den zumindest einen verbundenen Schallwandler, so dass die Art des Schallwandlers festgestellt werden kann.

Weitere Vorteile der Erfindung sind in den nachfolgenden Ausführungsbeispielen beschrieben. Es zeigen:
- **Figur 1**: ein Blockschaltbild einer Verstärkereinheit mit in einer externen Einheit angeordneten Schallwandlern und
- **Figur 2**: ein Blockschaltbild einer Verstärkereinheit in einem erweiterten Ausführungsbeispiel.

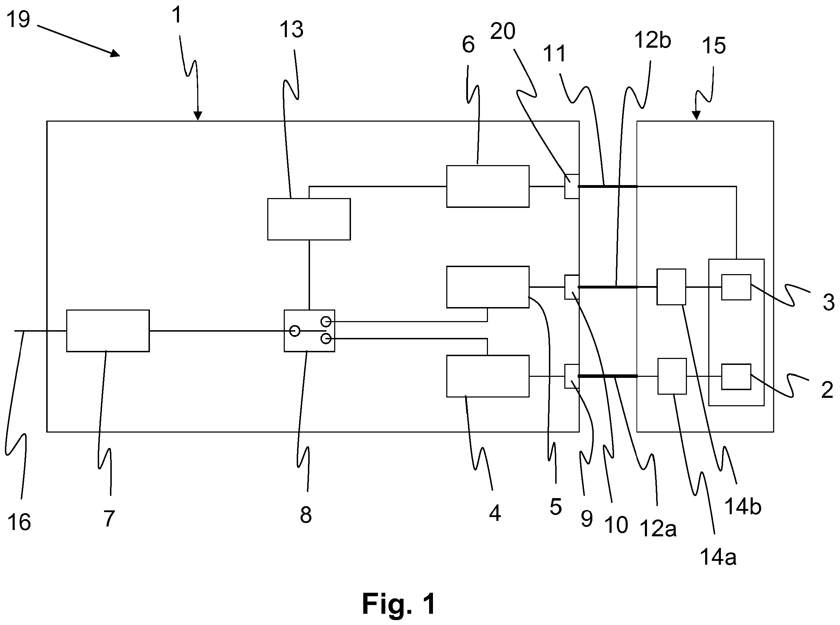

Figur 1 zeigt ein Blockschaltbild einer Verstärkereinheit 1 die mit in einer externen Einheit 15 angeordneten Schallwandlern 2, 3 verbunden ist. Die Verstärkereinheit 1 kann beispielsweise in einem, insbesondere mobilen, Gerät, beispielsweise einem Tablet oder Handy, verbaut sein. Die Schallwandler 2, 3 können dabei ein piezoelektrischer Schallwandler 2 und/oder ein dynamischer Schallwandler 3 sein. Die beiden Schallwandler 2, 3 können beispielsweise Lautsprecher sein, wobei die externe Einheit 15 beispielsweise als eine Lautsprecherbox oder als Kopfhörer ausgebildet ist. In diesem Ausführungsbeispiel sind jeweils ein piezoelektrischer Schallwandler 2 und ein dynamischer Schallwandler 3 gezeigt. Die beiden Schallwandler 2, 3 sind zur Erklärung der Funktionalität der Erfindung gezeigt. Generell kann nur ein Schallwandler 2 oder 3 und/oder es können beiden Schallwandler 2 und 3 vorhanden sein.

Für den Betrieb der Schallwandler 2, 3 wird die Verstärkereinheit 1 vorgeschlagen. Die Verstärkereinheit 1 ist dabei derart konfiguriert, dass diese ein Audiosignal verstärken und zur Ausgabe an die Schallwandler 2, 3 leiten kann. Die Verstärkereinheit 1 weist einen Eingang/Ausgang 16 auf, durch den beispielsweise das Audiosignal in die Verstärkereinheit 1 eingeleitet werden kann. Zusätzlich oder alternativ kann durch den Eingang/Ausgang 16 auch ein Audiosignal ausgegeben werden. Beispielsweise kann ein Audiosignal durch den Eingang/Ausgang 16 ausgegeben werden, wenn mittels der Schallwandler 2, 3 Schall aufgenommen wird. Die Schallwandler 2, 3 können dazu beispielsweise Mikrofone umfassen.

Die nachfolgende Beschreibung beschreibt im Wesentlichen ein Ausführungsbeispiel, bei dem die Schallwandler 2, 3 Lautsprecher umfassen. Das Audiosignal wird somit in der nachfolgenden Beschreibung vom Eingang/Ausgang 16 zu den Schallwandlern 2, 3 geleitet. Wenn die Schallwandler 2, 3 dagegen zusätzlich oder alternativ beispielsweise Mikrofone umfassen, wird das Audiosignal dabei lediglich von den Schallwandlern 2, 3 zum Eingang/Ausgang 16 geleitet, wobei die Funktionalität der Bauteile in der Verstärkereinheit 1 im Wesentlichen die gleiche ist. Beispielsweise kann nach einem Aufnehmen eines Tons durch die Schallwandler 2, 3 (die ein Mikrofon umfassen) durch einen Audioverstärker 4, 5 verstärkt werden und dann weiter zum Eingang/Ausgang 16 geleitet werden.

Dem Eingang/Ausgang 16 nachgeordnet weist die Verstärkereinheit 1 eine Signalvorbereitungseinheit 7 auf, in der das Audiosignal gefiltert und/oder vorverstärkt werden kann.

An die Signalvorbereitungseinheit 7 nachfolgend ist eine Schalteinheit 8 angeordnet, die das bearbeitete Audiosignal von der Signalvorbereitungseinheit 7 erhält. Die Schalteinheit 8 weist in diesem Ausführungsbeispiel zwei Schaltzustände auf. Bei dem einen Schaltzustand wird das Audiosignal zu einem ersten Audioverstärker 4 geleitet. Bei dem anderen Schaltzustand wird das Audiosignal zu einem zweiten Audioverstärker 5 geleitet. Dabei kann die Schalteinheit 8 auch mehrere Schaltzustände aufweisen, wenn beispielsweise mehrere Audioverstärker vorhanden sind. Zusätzlich oder alternativ kann die Schalteinheit 8 auch einen Schaltzustand aufweisen, bei dem das Audiosignal an beide Audioverstärker 4, 5 geleitet wird.

Die beiden Audioverstärker 4, 5 verstärken das Audiosignal, so dass es zu den Schallwandlern 2, 3 zugeführt werden kann und beispielsweise in einen Ton, eine Musik oder eine Sprache umgesetzt wird. Dem Audioverstärker 4 ist dazu eine erste Schnittstelle 9 nachgeordnet. Dem Audioverstärker 5 ist außerdem eine zweite Schnittstelle 10 nachgeordnet. Die Schnittstellen 9, 10 sind dabei vorteilhafterweise kabelgebunden, wobei von den Schnittstellen 9, 10 jeweils eine Audioleitung 12a, 12b zur externen Einheit 15 geführt ist. Die Schnittstellen 9, 10 können dabei beispielsweise eine USB-, eine Klinken-, eine Cinch- und/oder eine XLR-Schnittstelle sein. Wobei natürlich auch andere Schnittstellen denkbar sind. Durch die kabelgebundenen Schnittstellen 9, 10 kann die für den Betrieb der Schallwandler 2, 3 benötigte Energie über die Audioleitungen 12a, 12b zur externen Einheit 15 geleitet werden. Die externe Einheit 15 braucht dann keine eigene Energieversorgung aufweisen.

Der erste Audioverstärker 4 ist ferner über die ersten Schnittstelle 9 und über die Audioleitung 12a mit dem piezoelektrischen Schallwandler 2 verbunden. Der erste Audioverstärker 4 betreibt somit den piezoelektrischen Schallwandler 2.

Der zweite Audioverstärker 5 ist ferner über die zweite Schnittstelle 10 und über die Audioleitung 12b mit dem dynamischen Schallwandler 3 verbunden. Der zweite Audioverstärker 5 betreibt somit den dynamischen Schallwandler 3.

Die externe Einheit 15 kann des Weitern noch Filter 14a, 14b aufweisen, die den Schallwandlern 2, 3 vorgeschaltet sind und mittels denen das verstärkte Audiosignal bearbeitet und/oder gefiltert werden kann.

Die Verstärkereinheit 1 weist ferner eine Erkennungseinheit 6 auf, mittels der erkannt werden kann, ob die Schallwandler 2, 3 ein piezoelektrischer Schallwandler 2 und/oder ein dynamischer Schallwandler 3 sind. Die Erkennungseinheit 6 kann das Erkennen auch automatisiert durchführen. Dadurch kann erkannt werden, ob der piezoelektrische Schallwandler 2 und/oder der dynamische Schallwandler 3 in der externen Einheit 15 angeordnet ist. Die Erkennungseinheit 6 kann dazu über eine dritte Schnittstelle 20 und einer Testleitung 11, die in diesem Ausführungsbeispiel kabelgebunden ausgebildet ist, ein Testsignal an den zu erkennenden Schallwandler 2, 3 schicken. Der Schallwandler 2, 3 verändert dabei je nach Art des Schallwandlers 2, 3 das Testsignal und schickt es als Antwortsignal zurück an die Erkennungseinheit 6. Dabei müssen die Schallwandler 2, 3 das Antwortsignal nicht aktiv zurück schicken. Beispielsweise kann die Erkennungseinheit 6 erkennen, wie sich die Schallwandler 2, 3 verhalten, wenn ihnen das Testsignal geschickt wird. Dieses Verhalten kann dann als Antwortsignal gewertet werden.

Das Antwortsignal auf das Testsignal kann dabei beispielsweise von kapazitiver Natur sein. Die Erkennungseinheit 6 kann daraus schließen, dass ein piezoelektrischer Schallwandler 2 in der externen Einheit 15 angeordnet ist.

Zusätzlich oder alternativ kann das Antwortsignal auf das Testsignal auch von induktiver Natur sein, so dass die Erkennungseinheit 6 daraus schließt, dass ein dynamischer Schallwandler 3 in der externen Einheit 15 angeordnet ist.

Die Erkennungseinheit 6 kann beispielsweise als Testsignal die Testleitung 11 an die Schallwandler 2, 3 mit einer konstanten Spannung beaufschlagen. Der piezoelektrische Schallwandler 2 wird beispielsweise als kapazitives Antwortsignal nach einer gewissen Zeit (bedingt durch eine Aufladezeit einer Kapazität des piezoelektrischen Schallwandlers) einen Widerstand zurückgegeben, der sehr hoch sein wird. Dadurch ist ein Strom, der dann zum piezoelektrischen Schallwandler 2 fließt im Wesentlichen Null. Dadurch kann die Erkennungseinheit 6 erkennen, dass in der externen Einheit 15 der piezoelektrische Schallwandler 2 angeordnet ist.

Wenn die Erkennungseinheit 6 dagegen die Testleitung 11 an die Schallwandler 2, 3 mit einer konstanten Spannung beaufschlagt und ein induktives Antwortsignal erhält, kann die Erkennungseinheit 6 auf einen dynamischen Schallwandler 3 schließen. Dynamische Schallwandler 3 können eine Spule umfassen, die das induktive Antwortsignal zurück schickt. Das induktive Antwortsignal kann beispielsweise bei der konstanten Spannung ein konstanter von Null verschiedener Strom sein, da die Spule ein durchgehender Leiter ist. Der Strom kann beispielsweise durch einen Leitungswiderstand oder andere Bauteile in der externen Einheit 15 begrenzt sein. Die Erkennungseinheit 6 erkennt den konstanten von Null verschiedenen Strom und schließt deswegen auf den dynamischen Schallwandler 3 in der externen Einheit 15.

Zusätzlich oder alternativ kann das Testsignal auch über die Schnittstellen 9, 10 und über die Audioleitungen 12a, 12b zu den Schallwandlern 2, 3 geschickt werden. Die Erkennungseinheit 6 ist dazu mit den Schnittstellen 9, 10 verbunden.

Ebenfalls zusätzlich oder alternativ kann auch das Antwortsignal über die Audioleitungen 12a, 12b zurück zur Erkennungseinheit 6 geschickt wird. Die Erkennungseinheit 6 ist dazu mit den Schnittstellen 9, 10 verbunden.

Wenn das Testsignal von der Erkennungseinheit 6 über die Schnittstellen 9, 10 und über die Audioleitungen 12a, 12b zu den Schallwandlern 2, 3 geschickt wird, kann auf die Testleitung 11 verzichtet werden. Beispielsweise kann nachdem die externe Einheit 15 mit den Schallwandlern 2, 3 an die Verstärkereinheit 1 angeschlossen ist und noch bevor beispielsweise Musik durch die Schallwandler 2, 3 abgespielt wird, die Erkennungseinheit 6 das Testsignal über die Schnittstellen 9, 10 und über die Audioleitungen 12a, 12b schicken, um die Art der Schallwandler 2, 3 zu erkennen. Zusätzlich oder alternativ kann auch das Antwortsignal von den Schallwandlern 2, 3 über die Audioleitungen 12a, 12b und über die Schnittstellen 9, 10 zur Erkennungseinheit 6 zurückgeschickt werden. Beispielsweise kann auch erst nachdem die Art der Schallwandler 2, 3 von der Erkennungseinheit 6 erkannt ist, die Musik abgespielt werden.

Nach dem Erkennen der Art der Schallwandler 2, 3 kann die Erkennungseinheit 6 eine entsprechende Ergebnissignal an eine Steuereinheit 13 schicken. Die Steuereinheit 13 ist mit der Schalteinheit 8 verbunden, die dann derart geschalten werden kann, dass bei dem kapazitiven Antwortsignal der erste Audioverstärker 4 für den piezoelektrischen Schallwandler 2 beschaltet wird. Zusätzlich oder alternativ kann die Steuereinheit 13 die Schalteinheit 8 auch derart schalten, dass bei dem induktiven Antwortsignal der zweite Audioverstärker 5 beschalten wird, so dass der dynamische Schallwandler 3 betrieben wird.

Die Verstärkereinheit 1 und die externe Einheit 15 bilden des Weiteren eine Schallerzeugungseinheit 19. Die externe Einheit 15 kann auch fest mit der Verstärkereinheit 1 verbunden sein. Die Schallerzeugungseinheit 19 kann in diesem Fall beispielsweise in einem Smartphone, einem Laptop, Tablet o.ä. angeordnet sein. Die Schallwandler 2, 3 können dabei die internen Lautsprecher und/oder Mikrofone sein. Die Verstärkereinheit 1 kann beispielsweise in einem integrierten Schaltkreis, beispielsweise einem ASIC, in dem Smartphone angeordnet sein.

Zusätzlich oder alternativ kann die externe Einheit 15 auch lösbar mit der Verstärkereinheit 1 verbunden werden. Beispielsweise kann die Verstärkereinheit 1 in dem Smartphone angeordnet sein. Die externe Einheit 15 kann ferner ein Kopfhörer mit den Schallwandlern 2, 3 sein. Die Schallwandler 2, 3 können dann Lautsprecher umfassen, so dass beispielsweise Musik abgespielt werden kann. Die Schallwandler 2, 3 können zusätzlich oder alternativ auch Mikrofone umfassen, so dass beispielsweise Sprache aufgenommen werden kann. Beispielsweise kann mit den Schallwandlern 2, 3 Sprache abgegeben und aufgenommen werden.

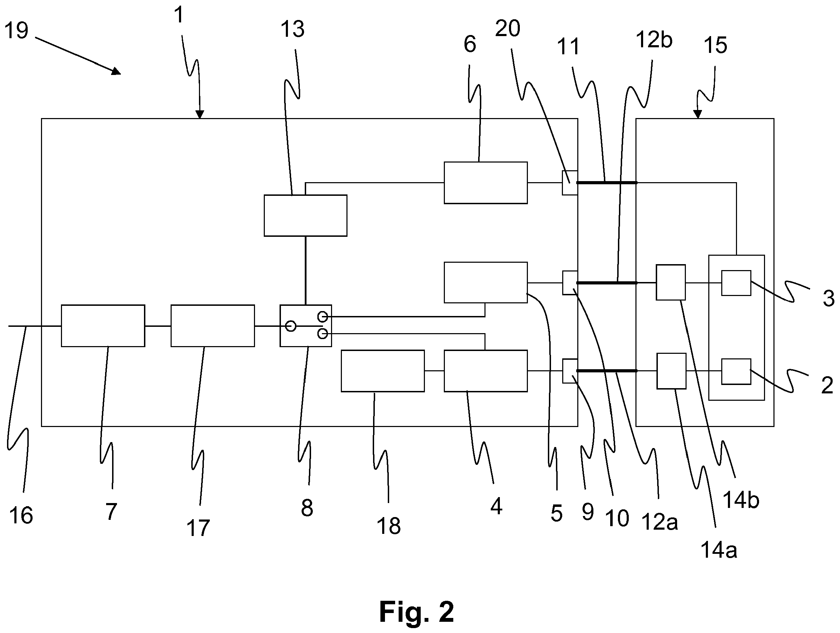

Figur 2 zeigt eine Verstärkereinheit 1 in einem erweiterten Ausführungsbeispiel. Die Verstärkereinheit 1 weist im Wesentlichen die gleichen Merkmale auf, wie sie bereits in der Figur 1 gezeigt sind. Daher soll nur auf die wesentlichen Unterschiede eingegangen werden.

Zwischen der Signalvorbereitungseinheit 7 und der Schalteinheit 8 ist in diesem Ausführungsbeispiel eine PWM-Einheit 17 (Pulsweitenmodulation-Einheit) angeordnet. Mittels der PWM-Einheit 17 kann das Audiosignal nach der Signalvorbereitungseinheit 7 digitalisiert werden. Das pulsweitenmodulierte Audiosignal wird dann von der Schalteinheit 8 an den ersten Audioverstärker 4 und/oder an den zweiten Audioverstärker 5 geleitet. Ein Vorteil davon ist, dass eine Verstärkung des pulsweitenmodulierten Audiosignals effizienter von den Audioverstärkern 4, 5 durchgeführt werden kann. Dadurch kann Energie eingespart werden.

Ferner weist die Verstärkereinheit 1 in diesem Ausführungsbeispiel eine Versorgungseinheit 18 auf, die den ersten Audioverstärker 4 mit elektrischer Spannung versorgt. Die Versorgungseinheit 18 kann beispielsweise aus geringen Spannungen, beispielsweise von 3-4 Volt, höhere Spannungen erzeugen. Dazu kann die Versorgungseinheit 18 beispielsweise einen Aufwärtswandler umfassen, der aus der geringen Spannung eine höhere Spannung erzeugt.

Zusätzlich kann der erste Audioverstärker 4 und/oder die Versorgungseinheit 18 eine hier nicht gezeigte Energierückgewinnungseinheit umfassen. Mittels dieser kann elektrische Energie vom piezoelektrischen Schallwandler 2, der eine Kapazität aufweist, zurückgewonnen werden. Die zurückgewonnene Energie kann wieder für den Betrieb des piezoelektrischen Schallwandlers 2 genutzt werden.

Die vorliegende Erfindung ist nicht auf die dargestellten und beschriebenen Ausführungsbeispiele beschränkt. Abwandlungen im Rahmen der Patentansprüche sind ebenso möglich wie eine Kombination der Merkmale, auch wenn diese in unterschiedlichen Ausführungsbeispielen dargestellt und beschrieben sind.

### Bezugszeichenliste

- 1: Verstärkereinheit
- 2: piezoelektrischer Schallwandler
- 3: dynamischer Schallwandler
- 4: erster Audioverstärker
- 5: zweiter Audioverstärker
- 6: Erkennungseinheit
- 7: Signalvorbereitungseinheit
- 8: Schalteinheit
- 9: erste Schnittstelle
- 10: zweite Schnittstelle
- 11: Testleitung
- 12: Audioleitung
- 13: Steuereinheit
- 14: Filter
- 15: externe Einheit
- 16: Eingang/Ausgang
- 17: PWM-Modul
- 18: Versorgungseinheit
- 19: Schallerzeugungseinheit
- 20: dritte Schnittstelle

## Patentansprüche

1. Verstärkereinheit (1) zum Betreiben eines piezoelektrischen Schallwandlers (2) und/oder eines dynamischen Schallwandlers (3) mit zumindest einem Audioverstärker (4, 5),
wobei die Verstärkereinheit (1) eine Erkennungseinheit (6) umfasst, mittels der, insbesondere automatisiert, erkennbar ist, ob ein mit der Verstärkereinheit (1) gekoppelter Schallwandler (2, 3) ein piezoelektrischer (2) oder ein dynamischer Schallwandler (3) ist,
**dadurch gekennzeichnet, dass** die Verstärkereinheit (1) derart konfiguriert ist, dass diese, insbesondere automatisiert nach dem Verbinden eines Schallwandlers (2, 3), ein Testsignal an den zumindest einen verbundenen Schallwandler (2, 3) schickt und dass die Erkennungseinheit (6) derart konfiguriert ist, dass diese ein auf das Testsignal resultierendes Antwortsignal des Schallwandlers (2, 3) empfängt und analysiert.

2. Verstärkereinheit nach dem vorherigen Anspruch, **dadurch gekennzeichnet, dass** die Verstärkereinheit (1) zumindest einen ersten Audioverstärker (4) zum Betreiben eines piezoelektrischen Schallwandlers (2) und einen zweiten Audioverstärker (5) zum Betreiben eines dynamischen Schallwandlers (3) umfasst.

3. Verstärkereinheit nach einem oder mehreren der vorherigen Ansprüche, **dadurch gekennzeichnet, dass** die Verstärkereinheit (1) zumindest eine, insbesondere kabelgebundene, Schnittstelle (9, 10, 20) umfasst, über die zumindest ein Schallwandler (2, 3) mit der Verstärkereinheit (1) und/oder der Erkennungseinheit (6) verbunden und/oder verbindbar ist.

4. Verstärkereinheit nach Anspruch 3, **dadurch gekennzeichnet, dass** die Schnittstelle (9, 10, 20) zumindest eine Testleitung (11) zum Verbinden der Erkennungseinheit (6) mit dem zumindest einen Schallwandler (2, 3) und/oder zumindest eine Audioleitung (12a, 12b) zum Verbinden zumindest eines Audioverstärkers (4, 5) mit dem zumindest einen Schallwandler (2, 3) umfasst.

5. Verstärkereinheit nach Anspruch 4, **dadurch gekennzeichnet, dass** die Schnittstelle (9, 10, 20), insbesondere die Testleitung (11) und/oder die Audioleitung (12a, 12b), bidirektional ausgebildet ist, so dass von der Verstärkereinheit (1) Signale an den zumindest einen Schallwandler (2, 3) geschickt und von diesem empfangen werden können.

6. Verstärkereinheit nach einem oder mehreren der vorherigen Ansprüche, **dadurch gekennzeichnet, dass** die Verstärkereinheit (1) eine Schalteinheit (8) aufweist, mittels der zumindest einer der Audioverstärker (4, 5) auswählbar ist, so dass ein Audiosignal zu diesem leitbar ist.

7. Verstärkereinheit nach Anspruch 6, **dadurch gekennzeichnet, dass** die Verstärkereinheit (1) eine Steuereinheit (13) zum Steuern der Schalteinheit (8) umfasst, die vorzugsweise zwischen der Schalteinheit (8) und der Erkennungseinheit (6) angeordnet und/oder mit diesen elektrisch verbunden ist.

8. Verstärkereinheit nach dem vorherigen Anspruch, **dadurch gekennzeichnet, dass** die Erkennungseinheit (6) und/oder die Steuereinheit (13) derart konfiguriert ist, dass diese, insbesondere automatisiert nach dem Verbinden eines Schallwandlers (2, 3), das Testsignal an den zumindest einen verbundenen Schallwandler (2, 3) schickt.

9. Verstärkereinheit nach einem oder mehreren der vorherigen Ansprüche, **dadurch gekennzeichnet, dass** die Erkennungseinheit (6) zwischen einem kapazitiven und einem induktiven Antwortsignal unterscheiden kann.

10. Verstärkereinheit nach Anspruch 9, **dadurch gekennzeichnet, dass** die Erkennungseinheit (6) derart konfiguriert ist, dass diese im Falle eines kapazitiven Antwortsignals einen piezoelektrischen Schallwandler (2) und im Falle eines induktiven Antwortsignals einen dynamischen Schallwandler (3) identifiziert und der Steuereinheit (13) ein korrespondierendes Ergebnissignal übermittelt.

11. Verstärkereinheit nach einem der Ansprüche 6 oder 7, **dadurch gekennzeichnet, dass** die Steuereinheit (13) derart konfiguriert ist, dass diese die Schalteinheit (8) in Abhängigkeit des Ergebnissignals ansteuert, so dass das Audiosignal an den ersten (4) und/oder den zweiten Audioverstärker (5) leitbar ist.

12. Verstärkereinheit nach einem oder mehreren der vorherigen Ansprüche, **dadurch gekennzeichnet, dass** die Verstärkereinheit (1) eine Versorgungseinheit (18) umfasst, mittels der dem ersten Audioverstärker (4) eine elektrische Spannung bereitstellbar ist.

13. Verstärkereinheit nach einem oder mehreren der vorherigen Ansprüche, **dadurch gekennzeichnet, dass** der erste Audioverstärker (4) eine Energierückgewinnungseinheit umfasst, mittels der elektrische Energie vom piezoelektrischen Schallwandler (2) zurückgewonnen werden kann.

14. Schallerzeugungseinheit mit zumindest einem Schallwandler (2, 3) und einer Verstärkereinheit (1), die ein Audiosignal verstärkt und dem Schallwandler (2, 3) zuführt, **dadurch gekennzeichnet, dass** die Verstärkereinheit (1) nach einem oder mehreren der vorherigen Ansprüche ausgebildet ist.

15. Verfahren zum Betreiben einer Verstärkereinheit (1) gemäß einem oder mehreren der vorherigen Ansprüche zum Betreiben eines piezoelektrischen Schallwandlers (2) und/oder eines dynamischen Schallwandlers (3), die zumindest einen Audioverstärker (4, 5) umfasst,
wobei mittels der Erkennungseinheit (6) der Verstärkereinheit (1), insbesondere automatisiert, erkannt wird, ob der mit der Verstärkereinheit (1) gekoppelte Schallwandler (2, 3) ein piezoelektrischer (2) oder ein dynamischer Schallwandler (3) ist,
**dadurch gekennzeichnet, dass** die Verstärkereinheit (1), insbesondere automatisiert nach dem Verbinden eines Schallwandlers (2, 3), ein Testsignal an den zumindest einen verbundenen Schallwandler (2, 3) schickt und dass die Erkennungseinheit (6) das auf das Testsignal resultierende Antwortsignal des Schallwandlers (2, 3) empfängt und analysiert.

## Claims

1. An amplifier unit (1) for operating a piezoelectric sound transducer (2) and/or a dynamic sound transducer (3), which comprises at least one audio amplifier (4, 5),
wherein the amplifier unit (1) includes a detection unit (6), with the aid of which it can be detected, in particular in an automated manner, whether a sound transducer (2, 3) coupled to the amplifier unit (1) is a piezoelectric sound transducer (2) or a dynamic sound transducer (3), **characterized in that**
the amplifier unit (1) is configured in such a way that, after a sound transducer (2, 3) has been connected, the amplifier unit (1) sends, in particular in an automated manner, a test signal to the at least one connected sound transducer (2, 3) and that the detection unit (6) is configured in such a way that it receives and analyzes a response signal of the sound transducer (2, 3) resulting from the test signal.

2. The amplifier unit as claimed in the preceding claim, **characterized in that** the amplifier unit (1) comprises at least a first audio amplifier (4) for operating a piezoelectric sound transducer (2) and a second audio amplifier (5) for operating a dynamic sound transducer (3).

3. The amplifier unit as claimed in one or more of the preceding claims, **characterized in that** the amplifier unit (1) includes at least one, in particular, cabled interface (9, 10, 20), via which at least one sound transducer (2, 3) is connected or can be connected to the amplifier unit (1) and/or to the detection unit (6).

4. The amplifier unit as claimed in claim 3, **characterized in that** the interface (9, 10, 20) comprises at least one test line (11) for connecting the detection unit (6) to the at least one sound transducer (2, 3) and/or at least one audio line (12a, 12b) for connecting at least one audio amplifier (4, 5) to the at least one sound transducer (2, 3).

5. The amplifier unit as claimed in claim 4, **characterized in that** the interface (9, 10, 20), in particular the test line (11) and/or the audio line (12a, 12b), is designed to be bidirectional, so that signals can be sent from the amplifier unit (1) to the at least one sound transducer (2, 3) and can be received by the at least one sound transducer (2, 3).

6. The amplifier unit as claimed in one or more of the preceding claims, **characterized in that** the amplifier unit (1) comprises a switching unit (8), with the aid of which at least one of the audio amplifiers (4, 5) can be selected, so that an audio signal can be routed thereto.

7. The amplifier unit as claimed in claim 6, **characterized in that** the amplifier unit (1) comprises a control unit (13) for controlling the switching unit (8) which is preferably situated between the switching unit (8) and the detection unit (6) and/or is electrically connected to the switching unit (8) and the detection unit (6).

8. The amplifier unit as claimed in the preceding claim, **characterized in that** the detection unit (6) and/or the control unit (13) are/is configured in such a way that, after a sound transducer (2, 3) has been connected, the detection unit (6) and/or the control unit (13) send/sends, in particular in an automated manner, the test signal to the at least one connected sound transducer (2, 3).

9. The amplifier unit as claimed in one or more of the preceding claims, **characterized in that** the detection unit (6) can preferably distinguish between a capacitive response signal and an inductive response signal.

10. The amplifier unit as claimed in claim 9, **characterized in that** the detection unit (6) is configured in such a way that it identifies a piezoelectric sound transducer (2) in the case of a capacitive response signal and it identifies a dynamic sound transducer (3) in the case of an inductive response signal, and it transmits a corresponding result signal to the control unit (13).

11. The amplifier unit as claimed in the claims 6 or 7, **characterized in that** the control unit (13) is configured in such a way that it actuates the switching unit (8) depending on the result signal, so that the audio signal can be routed to the first audio amplifier (4) and/or to the second audio amplifier (5).

12. The amplifier unit as claimed in one or more of the preceding claims, **characterized in that** the amplifier unit (1) includes a power supply unit (18), with the aid of which a voltage can be made available to the first audio amplifier (4).

13. The amplifier unit as claimed in one or more of the preceding claims, **characterized in that** the first audio amplifier (4) includes an energy recovery unit, with the aid of which electrical energy can be recovered from the piezoelectric sound transducer (2).

14. A sound-generation unit comprising at least one sound transducer (2, 3) and an amplifier unit (1), which amplifies an audio signal and feeds it to the sound transducer (2, 3), **characterized in that** the amplifier unit (1) is designed as claimed in one or more of the preceding claims.

15. A method for operating an amplifier unit (1) as claimed in one or more of the preceding claims for operating a piezoelectric sound transducer (2) and/or a dynamic sound transducer (3), which comprises at least one audio amplifier (4, 5),
wherein, with the aid of a detection unit (6) of the amplifier unit (1), it is detected, in particular in an automated manner, whether a sound transducer (2, 3) coupled to the amplifier unit (1) is a piezoelectric sound transducer (2) or a dynamic sound transducer (3), **characterized in that** after a sound transducer (2, 3) has been connected, the amplifier unit (1) sends a test signal to the at least one connected sound transducer (2, 3), in particular in an automated manner and that the detection unit (6) receives and analyzes a response signal of the sound transducer (2, 3) resulting from the test signal.

## Revendications

1. Unité d'amplificateur (1) pour faire fonctionner un transducteur acoustique piézoélectrique (2) et/ou un transducteur acoustique dynamique (3),
avec au moins un amplificateur audio (4, 5),
l'unité d'amplificateur (1) comprenant une unité de détection (6) au moyen de laquelle il est possible de détecter, en particulier automatiquement, si un transducteur acoustique (2, 3) couplé à l'unité d'amplificateur (1) est un transducteur acoustique piézoélectrique (2) ou un transducteur acoustique dynamique (3),
**caractérisée en ce que** l'unité d'amplificateur (1) est configurée manière à envoyer, en particulier automatiquement après la connexion d'un transducteur acoustique (2, 3), un signal de test à l'au moins un transducteur acoustique (2, 3) connecté, et **en ce que** l'unité de détection (6) est configurée de manière à recevoir et analyser un signal de réponse du transducteur acoustique (2, 3) résultant du signal de test.

2. Unité d'amplificateur selon la revendication précédente, **caractérisée en ce que** l'unité d'amplificateur (1) comprend au moins un premier amplificateur audio (4) pour faire fonctionner un transducteur acoustique piézoélectrique (2) et un second amplificateur audio (5) pour faire fonctionner un transducteur acoustique dynamique (3).

3. Unité d'amplificateur selon l'une quelconque ou plusieurs des revendications précédentes, **caractérisée en ce que** l'unité d'amplificateur (1) comprend au moins une interface (9, 10, 20), en particulier reliée par câble, par laquelle au moins un transducteur acoustique (2, 3) est relié et/ou peut être relié à l'unité d'amplificateur (1) et/ou à l'unité de détection (6).

4. Unité d'amplificateur selon la revendication 3, **caractérisée en ce que** l'interface (9, 10, 20) comprend au moins une ligne de test (11) pour relier l'unité de détection (6) à l'au moins un transducteur acoustique (2, 3) et/ou au moins une ligne audio (12a, 12b) pour relier au moins un amplificateur audio (4, 5) à l'au moins un transducteur acoustique (2, 3).

5. Unité d'amplificateur selon la revendication 4, **caractérisée en ce que** l'interface (9, 10, 20), en particulier la ligne de test (11) et/ou la ligne audio (12a, 12b), se présente(nt) sous une forme bidirectionnelle, de sorte que des signaux peuvent être envoyés depuis l'unité d'amplificateur (1) à l'au moins un transducteur acoustique (2, 3) et reçus depuis ce dernier.

6. Unité d'amplificateur selon l'une quelconque ou plusieurs des revendications précédentes, **caractérisée en ce que** l'unité d'amplificateur (1) présente une unité de commutation (8) au moyen de laquelle au moins l'un des amplificateurs audio (4, 5) peut être sélectionné de sorte qu'un signal audio puisse lui être dirigé.

7. Unité d'amplificateur selon la revendication 6, **caractérisée en ce que** l'unité d'amplificateur (1) comprend une unité de commande (13) pour commander l'unité de commutation (8), qui est de préférence disposée entre l'unité de commutation (8) et l'unité de détection (6) et/ou reliée électriquement avec ces dernières.

8. Unité d'amplificateur selon la revendication précédente, **caractérisée en ce que** l'unité de détection (6) et/ou l'unité de commande (13) est/sont configurée(s) de manière à envoyer, en particulier automatiquement après la connexion d'un transducteur acoustique (2, 3), le signal de test à l'au moins un transducteur acoustique (2, 3) connecté.

9. Unité d'amplificateur selon l'une quelconque ou plusieurs des revendications précédentes, **caractérisée en ce que** l'unité de détection (6) peut distinguer entre un signal de réponse capacitif et un signal de réponse inductif.

10. Unité d'amplificateur selon la revendication 9, **caractérisée en ce que** l'unité de détection (6) est configurée de manière à identifier un transducteur acoustique piézoélectrique (2) dans le cas d'un signal de réponse capacitif et un transducteur acoustique dynamique (3) dans le cas d'un signal de réponse inductif et à transmettre à l'unité de commande (13) un signal de résultat correspondant.

11. Unité d'amplificateur selon l'une quelconque des revendications 6 ou 7, **caractérisée en ce que** l'unité de commande (13) est configurée de manière à commander l'unité de commutation (8) en fonction du signal de résultat, de sorte que le signal audio peut être dirigé vers le premier (4) et/ou le second amplificateur audio (5).

12. Unité d'amplificateur selon l'une quelconque ou plusieurs des revendications précédentes, **caractérisée en ce que** l'unité d'amplificateur (1) comprend une unité d'alimentation (18) au moyen de laquelle une tension électrique peut être fournie au premier amplificateur audio (4).

13. Unité d'amplificateur selon l'une quelconque ou plusieurs des revendications précédentes, **caractérisée en ce que** le premier amplificateur audio (4) comprend une unité de récupération d'énergie au moyen de laquelle l'énergie électrique peut être récupérée du transducteur acoustique piézoélectrique (2).

14. Unité de génération de sons avec au moins un transducteur acoustique (2, 3) et une unité d'amplificateur (1) qui amplifie un signal audio et le fournit au transducteur acoustique (2, 3), **caractérisée en ce que** l'unité d'amplificateur (1) se présente sous une forme selon l'une quelconque ou plusieurs des revendications précédentes.

15. Procédé pour faire fonctionner une unité d'amplificateur (1) selon l'une quelconque ou plusieurs des revendications précédentes pour faire fonctionner un transducteur acoustique piézoélectrique (2) et/ou un transducteur acoustique dynamique (3), laquelle comprend au moins un amplificateur audio (4, 5),
dans lequel, au moyen de l'unité de détection (6) de l'unité d'amplificateur (1), il est détecté, en particulier automatiquement, si le transducteur acoustique (2, 3) couplé à l'unité d'amplificateur (1) est un transducteur acoustique piézoélectrique (2) ou un transducteur acoustique dynamique (3),
**caractérisé en ce que** l'unité d'amplificateur (1) envoie, en particulier automatiquement après la connexion d'un transducteur acoustique (2, 3), un signal de test à l'au moins un transducteur acoustique (2, 3) connecté, et **en ce que** l'unité de détection (6) reçoit et analyse le signal de réponse du transducteur acoustique (2, 3) résultant du signal de test.
